# EUROPEAN PATENT APPLICATION

(11) **EP 4 718 970 A1**
(43) Date of publication of application: **01.04.2026**
(21) Application number: 25193149.9
(22) Date of filing: 31.07.2025
(51) Int. Cl.: H10B 53/20, H10B 53/30, H10B 53/40

(54) **STACKED FERROELECTRIC RANDOM ACCESS MEMORY**

(30) Priority: 27.09.2024 US 202418900303
(71) Applicant: INTEL Corporation, Santa Clara, CA 95054 (US)
(72) Inventor: Chang, Sou-Chi, Portland, OR 97229 (US); Neumann, Christopher M., Portland, OR 97229 (US); Lin, Chia-Ching, Portland, OR 97229 (US); Liao, Yu-Ching, Portland, OR 97229 (US); Avci, Uygar E., Portland, OR 97225 (US); DSilva, Joseph, Hillsboro, OR 97124 (US); Huang, Cheng-Ying, Hillsboro, OR 97124 (US)
(74) Representative: Samson & Partner Patentanwälte mbB

(57) **Abstract**

An integrated circuit die includes an array of memory cells between a first surface and a second surface opposite the first surface. A first memory cell proximate the first surface comprises a first capacitor over a first transistor. A second memory cell under the first memory cell comprises a second capacitor under a second transistor. The first transistor may be stacked on the second transistor. The capacitors may include ferroelectric or antiferroelectric materials. The first capacitor is coupled with a first plate line located between the first surface and the array of memory cells. A via couples the second capacitor with a second plate line between the first surface and the array of memory cells.

## Description

### BACKGROUND

Memory circuitry and processing or other logic circuitry may be fabricated on the same integrated circuit (IC) die or chip. In comparison to systems in which memory and processing circuitry are in separate chips, the integration of both memory and processing logic proximate to one another in the same IC chip can provide improved performance. For example, communication between the memory and the processor in an IC die with embedded memory may be at higher bandwidths and/or lower access latencies relative to packaged IC chips communicating through package interconnects.

One type of embedded memory is based on memory cells that include a one transistor-one capacitor (1T-1C) architecture. The transistor is used to select a memory cell. The capacitor may be a conventional type having two electrodes separated by a dielectric material. However, an embedded memory with 1T-1C cells may employ capacitors in which the dielectric material is replaced with a ferroelectric (FE or F) or anti- ferroelectric (AFE or AF) material. A memory using FE/AFE capacitors may provide faster access and use less power as compared with a memory using conventional capacitors.

One challenge faced in implementing an embedded memory with memory cells that include FE/AFE capacitors is to make them compact while at the same time ensuring that read/write operations do not disturb neighboring memory cells.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Views referred to as "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure. Further, where considered appropriate, reference labels have been repeated among the figures to indicate corresponding or analogous elements. In the figures:
FIG. 1A illustrates a schematic of a memory cell and FIG. 1B illustrates a cross-section of a structure of the memory cell, in accordance with some embodiments;
FIG. 2 is a schematic of an integrated circuit that includes a memory, in accordance with some embodiments;
FIG. 3 illustrates an IC die that includes a memory, according to some embodiments;
FIG. 4 illustrates a schematic of memory circuitry, in accordance with some embodiments;
FIG. 5 is a cross-sectional illustration of a device corresponding with the memory circuitry of Fig. 4 that can be included in an array of memory cells within an IC die, in accordance with some embodiments;
FIG. 6 illustrates a schematic of memory circuitry, in accordance with some embodiments;
FIG. 7 is a cross-sectional illustration of a device corresponding with memory circuitry of FIG. 6 that can be included in an array of memory cells within an IC die, in accordance with some embodiments;
FIG. 8 illustrates an IC die that includes a memory according to some embodiments;
FIG. 9 illustrates a schematic of memory circuitry having two of memory cells, in accordance with some embodiments;
FIG. 10 is a cross-sectional illustration of a device corresponding with memory circuitry of FIG. 9, in accordance with some embodiments;
FIG. 11 illustrates a mobile computing platform and a data server machine employing one or more IC die described herein, in accordance with some embodiments; and
FIG. 12 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

Front-end-of-line (FEOL) semiconductor processing and structures refer to stages of IC fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires). FEOL fabrication stages may precede BEOL fabrication stages.

Back end of line (BEOL) semiconductor processing and structures refer stages of IC fabrication where the individual devices (e.g., transistors, capacitors, resistors, etc.) become interconnected with wiring on the wafer, e.g., the metallization or dielectric layers. BEOL includes contacts, insulating layers (dielectrics), metal levels, and bonding sites for chip-to-package connections. In the BEOL fabrication stages, contacts (pads), interconnect wires, vias and dielectric structures are formed. For modern 1C processes, more than 10 metal layers may be added in the BEOL.

Embodiments described herein are directed to integrated circuit (IC) dies that include a random access memory (RAM) memory. The RAM employs 1T-1C (one access transistor and one capacitor) memory cell architecture and capacitors the include ferroelectric (FE) or anti-ferroelectric (AFE) materials between terminals. In addition, the access transistors, the capacitors, and the memory cells may be arranged in stacked configurations. The RAMs described herein may be implemented as in an IC die as an embedded memory along with other circuitry that performs any desired function and uses the memory in performance of those functions, e.g., a cache memory for a processor. In other examples, the RAMs described herein may be implemented in a memory chip.

Advantageously, the FE (or AFE) RAM examples described herein may provide a memory with higher density, as compared with known RAMs. High density is achieved by configurations in which a first FE/AFE capacitor is placed over two stacked access transistors and a second FE/AFE capacitor is placed under the stacked access transistors. By stacking FE/AFE capacitors on the front and back sides of stacked access transistors, the cell density may be double that of known RAMs.

A further advantage is that the access transistors used in the example memories described herein provide high performance because they are fabricated using a high temperature FEOL process. Accordingly, the example memories described herein may be operated with higher performance, e.g., reliability, access latency, and power consumption, as compared with known RAMs. An additional advantage of some embodiments is that memory access lines may be placed in locations above and below the memory array, such that the footprint of the memory array within the IC die is smaller than it would otherwise be.

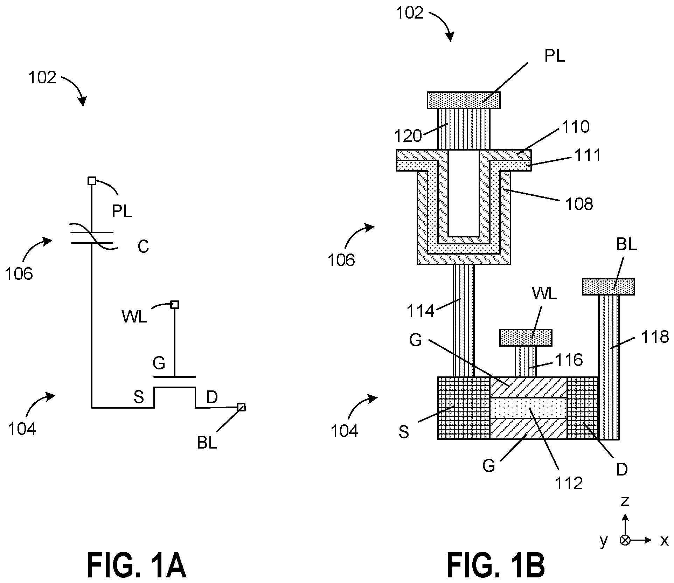

**FIG. 1A** illustrates a schematic of a 1T-1C memory cell, and FIG. **1B** is a cross-sectional illustration of an example structure for the 1T-1C memory cell that may be fabricated in an IC die, in accordance with some embodiments. The 1T-1C memory cell 102 includes an access transistor 104 and a capacitor 106. The memory cell 102 may be alternatively referred to as a "bit cell" or a "cell."

The access transistor 104 has a gate terminal, a source terminal, and a drain terminal, indicated in the figures herein as terminals G, S, and D, respectively. The gate terminal G is coupled to a word line (WL), the drain terminal D is coupled to a bit line (BL), and the source terminal S is coupled to a first electrode 108 of the capacitor 106. Gate terminal G, source terminal S, and drain terminal D may be alternatively referred to, respectively, as "gate electrode G," "source electrode S," and "drain electrode D." A second electrode 110 of the capacitor 106 is coupled to a plate line (PL). WL, BL, and PL are examples of "memory access lines." The WL, BL, and PL memory access lines are used together to read and program the capacitor 106. Access transistor 104 is fabricated using a high temperature FEOL process such that it may provide high performance in comparison to other types of access transistors and devices, e.g., diode circuits.

Memory cell 102 is used in an RAM-type memory according to various embodiments. The capacitor 106 includes a material 111 between the first and second electrodes 108, 110. The first and second electrodes 108, 110 may be alternatively referred to as "terminals." In some embodiments, the material 111 between the terminals 108, 110 includes a ferroelectric (FE) material. In some embodiments, the material 111 between the electrodes 108, 110 an antiferroelectric (AFE) material. When a voltage is applied to the capacitor 106, an electric field is created and the material 111 becomes polarized. When the electric field is removed, the material remains polarized. Two states of polarization, corresponding with the digital values of "1" and "0," are possible. The state of polarization is determined by the electric field, i.e., the applied voltage. For example, application of a first voltage +V across the capacitor causes a first polarization associated with a "1" and application of a second voltage -V causes a second polarization associated with a "0."

Material 111 may comprise hafnium, zirconium, or lanthanum. In some embodiments, FE or AFE material 111 includes hafnium doped with zirconium, where the proportion of zirconium may be adjusted to produce either an FE material or an AFE material. In other examples, material may include any suitable polarizable material. The first and second electrodes or terminals 108, 110 may comprise any of TiN, W, Mo, Nb, Ru, Ir, Au, Pt, or other suitable material.

Capacitor 106 is illustrated in FIG. 1B as having a trench type architecture, i.e., the first and second electrodes 108, 110, and the material 111 are "U" shaped. Capacitor 106 may have any other suitable architecture or shape. In other embodiments, capacitor 106 may have a fin type architecture, e.g., the first and second electrodes 108, 110, and the material 111 have the shape of an inverted "U." In other embodiments, capacitor 106 may have a planar architecture, e.g., the capacitor 106 is a three layer sandwich-like structure, with the material 111 in a layer between an upper layer including the first second electrode 108 and a lower layer including the second electrode 110.

In the example structure illustrated in FIG. 1B, the source electrode S is coupled to the capacitor 106 by a conductive via 114, the gate electrode G is coupled to the word line WL by a conductive via 116, and the drain electrode D is coupled to the bit line BL by a conductive via 118. In addition, the second electrode 110 of the capacitor 106 is coupled to plate line PL by a via 120. While the drain electrode D is coupled to bit line BL, and the source electrode S is coupled to capacitor 106 in the example of FIGs. 1A, 1B, in other examples, the drain electrode D is coupled to capacitor 106, and the source electrode S is coupled to bit line BL. This is because source and drain electrodes are interchangeable in field effect transistors. In some examples, any of the vias 114, 116, 118, and 120 may be omitted and replaced with a direct contact between an electrode and an access line, or by a direct contact between electrodes. The vias 114, 116, 118 may comprise Cu or any other suitable metal.

In various embodiments, the access transistor 104 may be any metal oxide semiconductor (MOS) transistor. Access transistor 104 includes a channel 112. In some examples, access transistor 104 includes a gate G that contacts more than one side of channel 112. In the illustrated example, the gate G contacts the top and bottom of channel 112, and a side surface "behind" the channel 112 in the view shown in FIG. 1B. (This side surface is hidden in the view shown in FIG. 1B.) In some examples, the gate G contacts the top and bottom surfaces of channel 112, and the portions of the gate contacting these surfaces are coupled by a via. In yet other examples, the gate G contacts the top and bottom surfaces, and the both side surfaces of channel 112, i.e., the gate G may surround the channel 112.

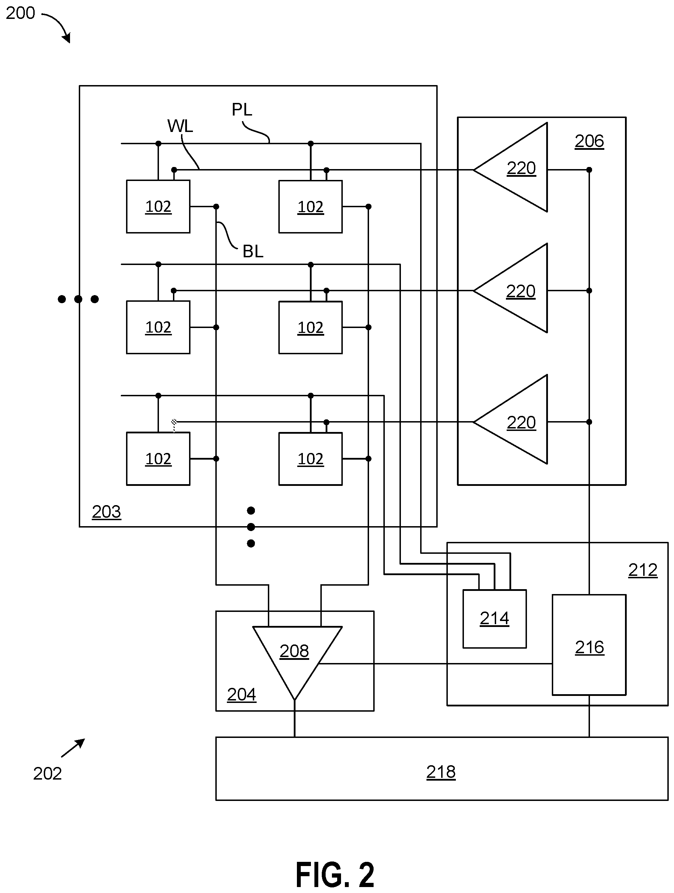

**FIG.** 2 is a schematic of an integrated circuit (IC) 200 that includes a memory 202, in accordance with some embodiments. The memory 202 includes an array of memory cells 203 comprising a plurality of memory cells 102, described above with reference to FIG. 1, and peripheral memory circuitry to implement an access of the memory cells 102. The memory 202 includes conductive traces including multiples memory access lines, such as multiple bit lines BL, multiple word lines WL, and multiple capacitor plate lines PL. The peripheral memory circuitry (or "peripheral circuitry") comprises column circuitry 204, row circuitry 206, and control circuitry 212. FIG. 2 also illustrates host logic circuitry 218.

The peripheral memory circuitry includes transistors and/or other active circuit components. In addition, the peripheral memory circuitry further includes one or more layers of interconnect metallization embedded in dielectric material layers. For example, multiple bit lines BL may be coupled to a sense amplifier 208 in column circuitry 204. Multiple word lines WL may be coupled to word line drivers 220 in row circuitry 206.

One or more of column circuitry 204, and/or row circuitry 206, and/or memory array 203 may be coupled to control circuitry 212. Control circuitry 212 may include, for example, various voltage biasing circuits, such as capacitor bias circuitry 214 that may include a charge pump that can be independently coupled to individual ones of a plurality of the plate lines PL. Control circuitry 212 may also include, for example, various memory management circuitry, such as control logic 216 communicatively coupled into column circuitry 204 and row circuitry 206 so as to permit coordinated operation of sense amplifier 208 and word line driver 220.

In some embodiments, any or all of the peripheral memory circuitry components (column circuitry 204, row circuitry 206, and control circuitry 212) may be fabricated in a device level of an IC die under or below a level in which the array of memory cells 203 is fabricated. In other embodiments, any or all of the peripheral memory circuitry components (column circuitry 204, row circuitry 206, and control circuitry 212) may be fabricated in a different region than the region of an 1C die in which the array of memory cells 203 is fabricated. In these embodiments, the peripheral memory circuitry components may be fabricated in a same device level of an IC die as the level the array of memory cells 203 is fabricated. In some embodiments, the peripheral memory circuitry components may include NMOS, PMOS, or CMOS FETs fabricated in a device layer that is at least partially underlying the array of memory cells 203. In some embodiments, the peripheral memory circuitry components may include NMOS, PMOS, or CMOS FETs fabricated in a different region of the IC die than the region in which the array of memory cells 203 is fabricated.

To perform a read or write operation on an individual memory cell, row circuitry 206 is used to turn on the access transistor 104 in a cell using a word line WL and column circuitry 204 may be used to store a value, or sense the value stored in the cell, using a bit line BL. In some examples, row circuitry 206 uses a single word line WL for all cells in a row. In some examples, column circuitry uses a single bit line for all cells in a column. In a read/write operation, a voltage is placed across the capacitor 106 using the bit line BL in conjunction with the plate line PL. The voltage across the capacitor may be positive or negative, such that the electric field created by the voltage places the material 111 in one of two states of polarization. The capacitor bias circuitry 214 may be used to control the voltage on the plate line PL for particular memory cell. In some embodiments, a single plate line is used for all memory cells in a row, i.e., when the capacitor bias circuitry 214 controls the voltage on a plate line PL, it sets the PL voltage for all memory cells in the same row. In other embodiments, each cell has an independent plate line, i.e., the capacitor bias circuitry 214 may control the voltage on the plate line PL for an individual cell without changing or affecting the PL voltage on other cells in the same row. In various embodiments, plate lines PL run parallel to word lines WL, while bit lines BL run orthogonal to the plate lines PL and bit lines BL.

In some examples, IC 200 further includes host logic circuitry 218. Host logic circuitry 218 is a primary consumer of memory bandwidth supplied by memory array 203. Host logic circuitry 218 may be any application specific IC (ASIC) including one or more IP cores. In some embodiments, host logic circuitry 218 comprises a processor core. In other embodiments, host logic circuitry 218 comprises any of a processor core, a wireless radio circuit, or other logic. In some embodiments, the host logic circuitry 218 may include NMOS, PMOS, or CMOS FETs fabricated in a device layer that is at least partially underlying an array of memory cells 203. In some embodiments, the host logic circuitry 218 may include NMOS, PMOS, or CMOS FETs fabricated in a different region of the IC die than the region in which the array of memory cells 203 is fabricated.

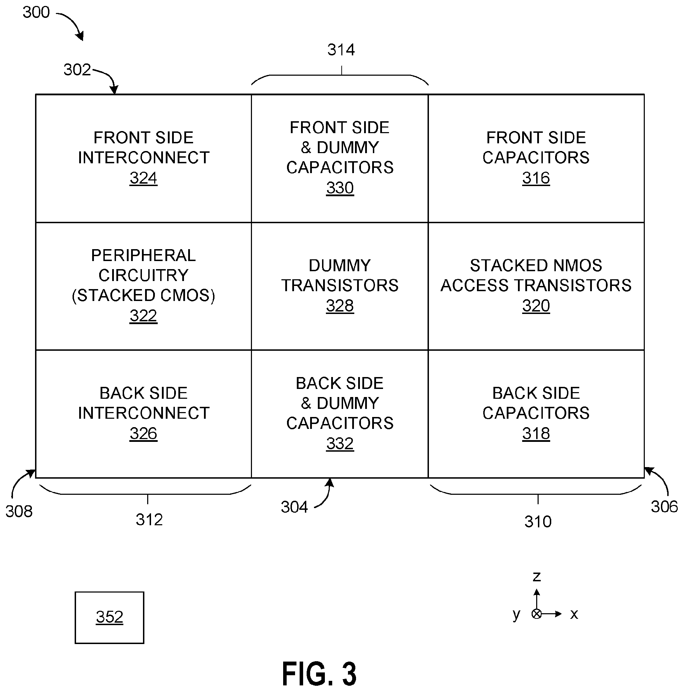

**FIG.** 3 illustrates an 1C die 300 that includes a memory, that may be the same as or similar to the memory 202, according to some embodiments. The memory of IC die 300 includes an array of memory cells 203 and peripheral memory circuitry 322. IC die 300 includes first surface 302 and a second surface 304 opposite the first side. First surface 302 may also be referred to as a "front side." Second surface 304 may also be referred to as a "back side." IC die 300 also includes sides extending between and orthogonal to the first and second surfaces 302, 304. In the view presented in FIG. 3, side 306 is at the right and side 308 is at the left. The first and second surfaces 302, 304 may be referred to as "sidewalls."

IC die 300 includes a first region 310, a second region 312, and a transition region 314. In the view presented in FIG. 3, first region 310 is at side 306 and second region 312 is at side 308. In other examples, first region 310 may be near side 306 and second region 312 may be near side 308. The side at which first and second regions 310, 312 are at or near may be varied, e.g., first region 310 may be at side 308 and second region 312 may be at side 306. In various embodiments, the second region 312 is between the first region 310 and one of the sides that is orthogonal to the first surface 302 and a second surface 304. For example, the second region 312 is between the first region 310 and the side 308. The second region 312 is positioned laterally (x- or y-direction), rather than vertically (z-direction), with respect to the first region 310.

The regions 310, 312, and 314 extend vertically (z-direction) between the first and second surfaces 302, 304. In some embodiments, the regions 310, 312, and 314 may extend only part of the distance between the first and second surfaces 302, 304.

In the illustrated example, first region 310 extends in the x-direction to side 306 and second region 312 extends in the x-direction to side 308. First and second regions 310, 312 may extend in the y-direction various distances. In some examples, first and second regions 310, 312 may extend in the y-direction through the entire IC die to a side (not shown). In other examples, first and second regions 310, 312 may extend in the y-direction by distances that are less than y-dimension of the IC die.

The array of memory cells 203 in IC die 300 comprise front side capacitors 316 proximate to front side 302, back side capacitors 318 proximate to back side 304, and stacked NMOS access transistors 320, all within first region 310. Front side capacitors 316 and back side capacitors 318 may be the same as or similar to capacitors 106. NMOS access transistors 320 may be the same as or similar to access transistors 104. As descried below, access transistors 320 are configured in a stacked arrangement. In addition, while not shown in FIG. 3, word lines WL and bit lines BL may be routed through front side layers between the access transistors 320 and the front side capacitors 316. In addition, while not shown in FIG. 3, one or more plate lines PL may either be routed between front side 302 and front side capacitors 316, or between back side 304 and back side capacitors 318, or in both locations.

Peripheral memory circuitry 322, front side interconnect 324, and back side interconnect 326 are located within second region 312. Peripheral memory circuitry 322 comprises column circuitry 204, row circuitry 206, and control circuitry 212. The peripheral memory circuitry 322 includes transistors and/or other active circuit components. The peripheral memory circuitry 322 is coupled with the array 203 of memory cells, including the memory access lines WL, BL, and PL. In embodiments, the peripheral memory circuitry 322 includes stacked CMOS transistors. In addition, the peripheral memory circuitry 322 further includes one or more layers of interconnect metallization embedded in dielectric material layers. In some embodiments, the peripheral memory circuitry 322 in the second region is coupled with the plate lines PL in the first region. In some embodiments, the peripheral memory circuitry 322 comprises capacitor biasing circuitry comprising CMOS transistors.

A transition region 314 is between first region 310 and second region 312. The transition region 314 may be required because various manufacturing processes do not permit a sharp transition between adjacent regions. In this example, transition region 314 comprises dummy transistors 328, front side interconnects and dummy capacitors 330, and back side interconnects and dummy capacitors 332. The width of the transition region 314 depicted may not be to scales as the width (x-dimension) is typically a few microns, e.g., 5 µm. In some examples, the transition region 314 extends from the first surface 302 to the second surface 304.

While not shown in FIG. 3, IC die 300 may include host logic circuitry 218. For example, host logic circuitry 218 may be fabricated in second region 312 adjacent to peripheral memory circuitry 322.

FIG. 3 also illustrates a power supply 352. IC die 300 may be attached and coupled to a substrate, which in turn may include and/or be coupled with power supply 352. While various implementations are possible, the power supply 352 serves to power the memory circuitry and device circuitry within IC die 300.

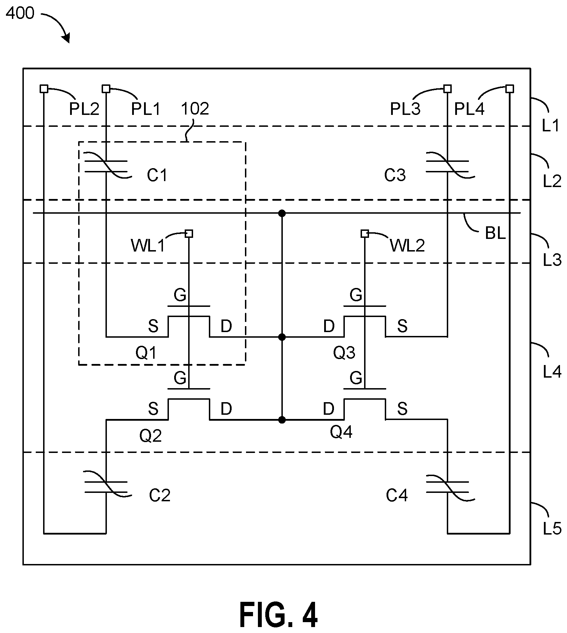

**FIG.** 4 illustrates a schematic of memory circuitry 400 having four of memory cells 102, in accordance with some embodiments. Access transistors 104 in the respective memory cells are labeled Q1, Q2, Q3 and Q4. The gate terminals of access transistors Q1 and Q2 are connected. Similarly, gate terminals of access transistors Q3 and Q4 are connected. Word line WL1 is coupled with the gates G of both of access transistors Q1 and Q2. Word line WL2 is coupled with the gates G of both of access transistors Q3 and Q4. Bit line BL is coupled with the drain terminals D of all of the access transistors Q1, Q2, Q3 and Q4. Capacitors 106 in the respective memory cells are labeled C1, C2, C3 and C4. Each of the capacitors has a first terminal coupled with the source terminal S of a respective capacitor, and a second terminal coupled with a respective one of the plate lines PL1, PL2, PL3, and PL4.

FIG. 4 schematically illustrates that capacitors C1 and C3 are in layer L2, access transistors Q1, Q2, Q3, and Q4 are in layer L4, and capacitors C2 and C4 are in a layer L5. Word lines WL and bit lines BL are in a layer L3 between layer L2 and layer L4. Word lines WL and bit lines BL are orthogonal to one another. Plate lines PL1, PL2, PL3, and PL4 are in layer L1, which is over capacitors C1 and C3 in layer L2.

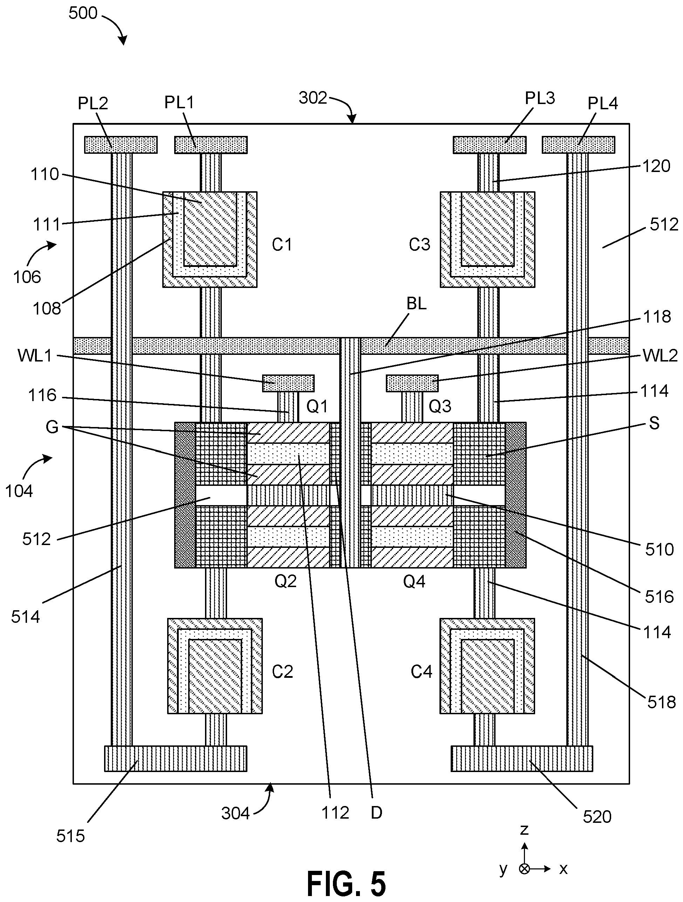

FIG. 5 is a cross-sectional illustration of a device 500 corresponding with memory circuitry 400, in accordance with some embodiments. In various embodiments, an IC die comprising an array 203 of memory cells 102 includes one or more of the device 500 illustrated in FIG. 5. In the IC die, the array 203 of memory cells 102 is between a first surface 302 and second surface 304. The illustrated device 500 includes four of the memory cells 102.

A first memory cell is proximate the first surface 302, and includes a first capacitor C1 and a first transistor Q1. Because capacitor C1 is closer to the front side (first surface 302) than transistor Q1, the first capacitor C1 is located over the first transistor Q1. As shown the figures, first capacitor C1 is adjacent to first transistor Q1. The first capacitor C1 includes material 111 between first electrode 108 and second electrode 110. First electrode 108 may be alternatively referred to as a "first terminal" and second electrode 110 may be alternatively referred to as a "second terminal." The first transistor Q1 includes a first gate electrode G, a first source S electrode, and first drain electrode D. The first source S electrode is coupled with the first terminal 108. The first source electrode S may be coupled first terminal 108 conductive via 114. A dielectric or insulating spacer 516 may contact one or more sides of first source electrode S. The dielectric or insulating spacer 516 may comprise a different material than dielectric 512. The first transistor Q1 is stacked on or over a second transistor Q2.

In device 500, a second memory cell is under the first memory cell. The second memory cell includes second capacitor C2 and the second transistor Q2. Because the second transistor Q2 is closer to the front side (first surface 302) than the second capacitor C2, the second capacitor C2 is under the second transistor Q2. The first gate electrode G of first transistor Q1 and the second gate electrode G of second transistor Q2 are vertically adjacent, e.g., the gates are arranged in a stack. Similarly, the first source S electrode is vertically adjacent to the second source S electrode, and the first drain electrode D is vertically adjacent to the second drain D electrode. While the gates G of the first and second transistors Q1, Q2 may be spaced apart by a spacer material 510, the spacer material 510 is a metal that contacts each of the gates and electrically couples the gates G of transistors Q1, Q2. The respective sources and drains of transistors Q1, Q2 are spaced apart by a dielectric material 512. Except as noted herein or shown in the figures, the second memory cell includes features that are substantially the same as the first memory cell.

Device 500 includes a third memory cell is proximate the first surface and laterally adjacent to the first memory cell. The third memory cell includes a third capacitor C3 over a third transistor Q3. Except as noted herein or shown in the figures, the third memory cell includes features that are substantially the same as the first memory cell, e.g., the third transistor Q3 is stacked on or over a fourth transistor Q4.

Device 500 includes a fourth memory cell is under the third memory cell. The fourth memory cell includes a fourth capacitor C4 under a fourth transistor Q4. Except as noted herein or shown in the figures, the third memory cell includes features that are substantially the same as the second memory cell, e.g., the fourth capacitor C4 is under the fourth transistor Q4, and the gates G of transistors Q3 and Q4 may be coupled by conductive spacer material 510.

In device 500, first plate line PL1, second plate line PL2, third plate line PL3, and fourth plate line PL4 are between the front side (first surface 302) and the array of memory cells, e.g., plate lines PL1, PL2, PL3, and PL4 are over the first, second, third, and fourth memory cells. The first plate line PL1 is coupled with the second terminal or electrode 110 of first capacitor C1. The third plate line PL3 is coupled with the second terminal or electrode 110 of third capacitor C3. In some examples, the second electrode 110 may be coupled with the plate line by a conductive via 120 comprising a metal, e.g., Cu. In other examples, conductive via 120 may be omitted and the plate line may be on the second electrode 110, and coupled by the direct contact between the two features. Plate lines PL1, PL2, PL3, and PL4 may extend in a direction parallel to word lines WL1 and WL2. Plate lines PL1, PL2, PL3, and PL4 may extend in a direction orthogonal to bit lines BL.

A first conductive via 514 and a horizontal metal feature 515 electrically couple the second terminal or electrode 110 of second capacitor C2 with the second plate line PL2. Similarly, a second conductive via 518 and horizontal metal feature 520 electrically couple the second terminal or electrode 110 of fourth capacitor C4 with the fourth plate line PL4. The conductive via 514 may be laterally adjacent to both of the first and second memory cells. Similarly, conductive via 518 may be laterally adjacent to both of the third and fourth memory cells. The conductive vias 514, 518 may extend from a layer proximate the front side to a layer proximate the back side.

In addition to plate lines PL1, PL2, PL3, and PL4, device 500 includes first memory access lines, e.g., bit line BL, and second memory access lines, e.g., word lines WL1, WL2. Bit line BL is between the first and third transistors Q1, Q3 and the first and third capacitors C1, C3. Similarly, word lines WL1, WL2 are between the first and third transistors Q1, Q3 and the first and third capacitors C1, C3. Word lines WL1 and WL2 may extend in a direction orthogonal to bit line BL.

The first drain electrode D of transistor Q1 is vertically adjacent to the second drain electrode D of transistor Q2. A conductive via 118 contacts bit line BL and both of drain electrodes D of Q1 and Q2. The third drain electrode D of transistor Q3 is vertically adjacent to the fourth drain electrode D of transistor Q4. In addition, the drain electrodes D of Q1 and Q3 are laterally adjacent and proximate one another. Similarly, the drain electrodes D of Q2 and Q4 are laterally adjacent and proximate one another. Because these features are near one another, conductive via 118 may also contact bit line BL and both of drain electrodes D of Q3 and Q4. In some examples, conductive via 118 is between drain electrodes D of Q1 and Q3, and between drain electrodes D of Q3 and Q4.

As mentioned, the gates G of transistors Q1 and Q2 are coupled, and the gates and the gates G of transistors Q3 and Q4 are coupled. The gate electrode G of transistor Q1 is coupled with word line WL1. The gate electrode G of transistor Q3 is coupled with word line WL2. In some examples, the gate electrodes of Q1 and Q3 may be coupled with the respective word line by a conductive via 116 comprising a metal, e.g., Cu. In other examples, conductive via 116 may be omitted and the plate line may be on the gate electrode, electrically coupling the word line with the gate electrode by direct contact.

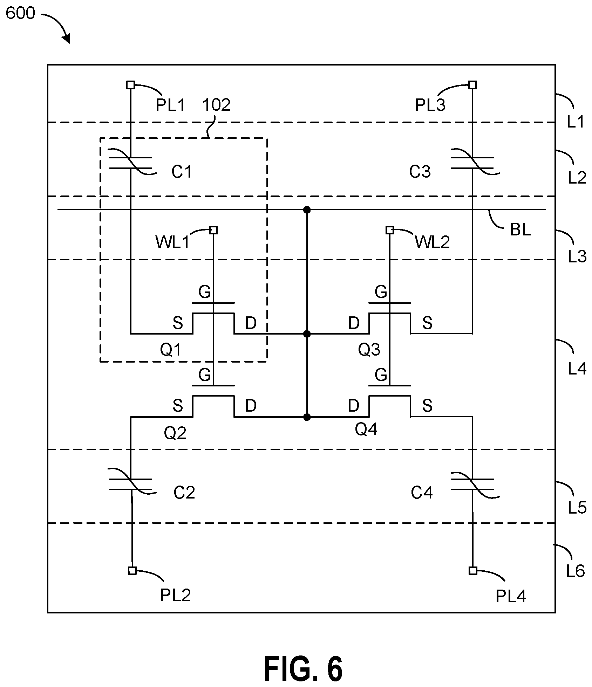

**FIG.** 6 illustrates a schematic of memory circuitry 600 having four of memory cells 102, in accordance with some embodiments. Except as noted herein or shown in the figures, memory circuitry 600 includes features that are substantially the same as memory circuitry 400. In memory circuitry 600, plate lines PL1 and PL3 are in layer L1, which is over capacitors C1 and C3 in layer L2. The plate lines PL2 and PL4 are in a layer L6, which is under capacitors C2 and C4 in layer L5. In some examples, plate lines PL2 and PL4 are proximate back side 304 and between capacitors C2 and C4 and the back side 304. In some embodiments, the layer L6 corresponds with a back side power delivery layer or layers and the plate lines PL2 and PL4 are in the back side power delivery layer or layers.

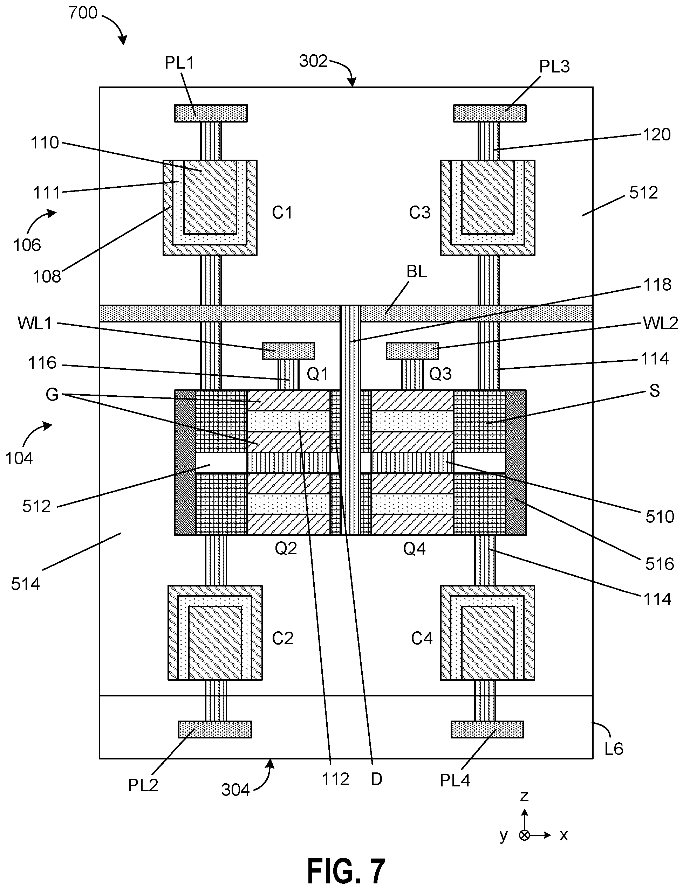

**FIG.** 7 is a cross-sectional illustration of a device 700 corresponding with memory circuitry 600, in accordance with some embodiments. In various embodiments, an IC die comprising an array 203 of memory cells 102 includes one or more of the device 700 illustrated in FIG. 7. In the IC die, the array 203 of memory cells 102 is between a first surface 302 and second surface 304. The device 700 includes four of the memory cells 102. Except as noted herein or shown in the figures, device 700 includes features that are substantially the same as device 500.

In device 700, first and third plate lines PL1, PL3 are between the front side (first surface 302) and the array of memory cells, e.g., plate lines PL1 and PL3 are over the first, second, third, and fourth memory cells. The plate lines PL2, PL4 are between the back side (second surface 304) and the array of memory cells, e.g., plate lines PL2 and PL4 are under the first, second, third, and fourth memory cells. The conductive vias 514, 518 employed in device 500 are omitted in device 700, which advantageously allows device 700 to be fabricated with a smaller footprint than device 700.

In some embodiments, back side interconnect structures may be in a back side power delivery layer or layers between back side 304 and back side capacitors 318. The back side power delivery layer may include a plurality of power interconnects. A power interconnect includes any suitable combination of conductive vias and conductive lines together with one or more layers of a suitable dielectric to isolate the power interconnects. A power interconnect may be coupled with a contact or pad on a side, e.g., the back side, of the IC die and any circuitry within the IC die, such as a transistor within a memory array or peripheral memory circuitry. In some embodiments, plate lines PL2, PL4 are located in one or more of the power delivery layer or layers. In some embodiments, one or more power interconnects are coupled with a power supply to provide power to a memory array, peripheral memory circuitry, or other circuitry within the IC die.

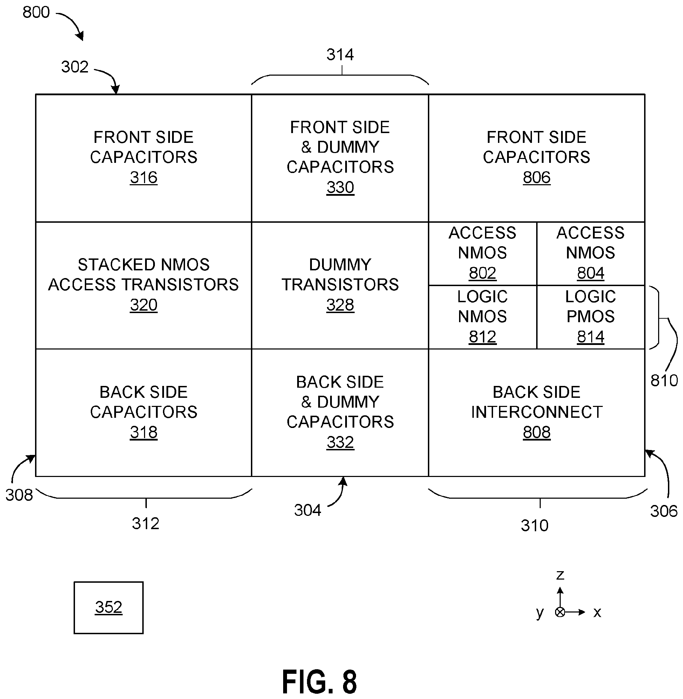

**FIG.** 8 illustrates an IC die 800 that includes a memory, that may be the same as or similar to the memory 202, according to some embodiments. The memory of IC die 800 includes an array of memory cells 203 and peripheral memory circuitry. 1C die 800 includes first surface 302 and a second surface 304 opposite the first surface. In the view presented in FIG. 8, side 306 is at the right and side 308 is at the left. IC die 300 includes a first region 310, a second region 312, and a transition region 314. The regions 310, 312, and 314 may be the same as or similar to those describe with respect to FIG. 3.

In IC die 800, front side capacitors 316, back side capacitors 318, and stacked NMOS access transistors 320 may be within first region 312. Like IC die 300, IC die 800 includes a transition region 314 is between first region 310 and second region 312.

The array of memory cells 203 in IC die 800 includes front side capacitors 806 and access transistors 802, 804 in region 310. Front side capacitors 806 are proximate to front side 302. The access transistors 802, 804 are stacked over logic transistors 812, 814. A portion 810 of the region 310 includes the logic transistors 812, 814. In some embodiments, portion 810 includes peripheral memory circuitry, and logic transistors 812, 814 are included in the peripheral memory circuitry. In some embodiments, portion 810 includes host circuitry or other logic circuitry, and logic transistors 812, 814 are included in the host or other logic memory circuitry. Back side interconnect 808 is between logic transistors 812, 814 and second surface 304. In some examples, back side interconnect 808 may include redistribution layers. In some examples, back side interconnect 808 may include a plurality of power interconnects.

In region 310, word lines WL and bit lines BL are routed through between the access transistors 802, 804 and the front side capacitors 806. In addition, one or more plate lines PL may either be routed between front side 302 and front side capacitors 806.

While not shown in FIG. 8, IC die 800 may include host logic circuitry 218, peripheral memory circuitry 322, or both of circuitry 218, 322. For example, host logic circuitry 218 or peripheral memory circuitry 322 may be fabricated in portion 810 of first region 310.

FIG. 8 also illustrates a power supply 352. IC die 800 may be attached and coupled to a substrate, which in turn may include and/or be coupled with power supply 352. While various implementations are possible, the power supply 352 serves to power the memory circuitry and device circuitry within IC die 800.

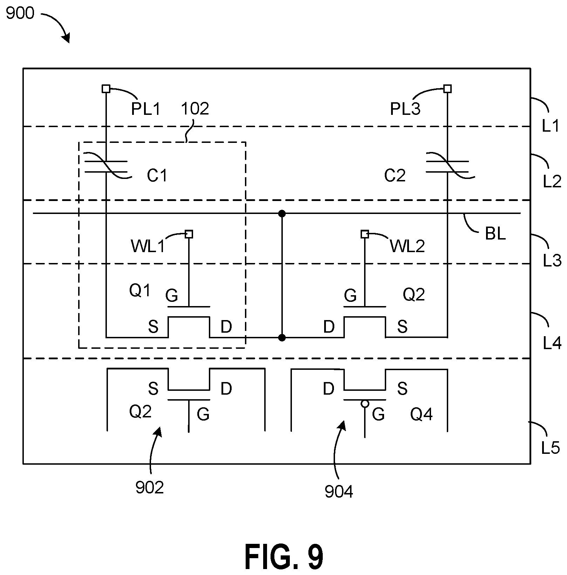

**FIG.** 9 illustrates a schematic of memory circuitry 900 having two of memory cells 102, in accordance with some embodiments. Except as noted herein or shown in the figures, memory circuitry 900 includes features that are substantially the same as memory circuitry 400. In memory circuitry 900, plate lines PL1 and PL2 are in layer L1, which is over capacitors C1 and C2 in layer L2. NMOS transistor 902 and PMOS transistor 904 are in layer L5, which is under access transistors Q1 and Q2 in layer L4. Word lines WL1 and WL2, and bit line BL are between access transistors Q1 and Q2 and capacitors C1 and C2.

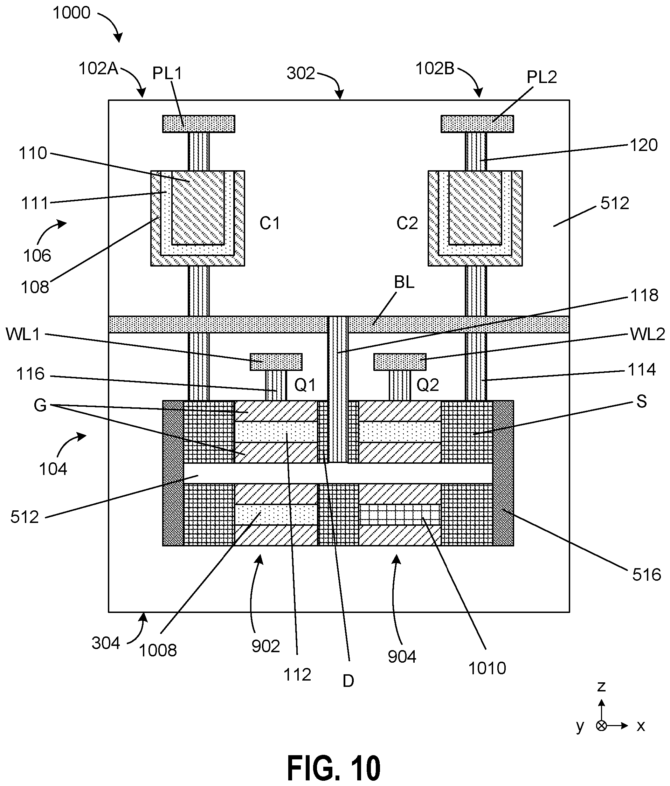

**FIG. 10** is a cross-sectional illustration of a device 1000 corresponding with memory circuitry 900, in accordance with some embodiments. In various embodiments, an IC die comprising an array 203 of memory cells 102 includes one or more of the device 1000 illustrated in FIG. 10. In the IC die, the array 203 of memory cells 102 is between a first surface 302 and second surface 304. The device 1000 includes two of the memory cells 102. Except as noted herein or shown in the figures, device 1000 includes features that are substantially the same as device 500.

Device 1000 includes a first memory cell 102A proximate the first surface 302, and a second memory cell 102B proximate the first surface and laterally adjacent to the first memory cell. The first memory cell 102A includes a first capacitor C1 over a first access transistor Q1. The second memory cell 102B includes a second capacitor C2 over a second access transistor Q2.

NMOS transistor 902 is below and adjacent to first access transistor Q1. PMOS transistor 904 is below and adjacent to second access transistor Q2. NMOS transistor 902 includes a channel region comprising an n-type semiconductor material 1008. PMOS transistor 904 includes a channel region comprising a p-type semiconductor material 1010.

In some examples, first access transistor Q1 is stacked on or over NMOS transistor 902, and second access transistor Q2 is stacked on or over PMOS transistor 904. A dielectric material 512 may be between the stacked transistors. In some examples, the gate electrode G of access transistor Q1 is proximate and vertically adjacent to the gate electrode of NMOS transistor 902. In some examples, the gate electrode G of access transistor Q2 is proximate and vertically adjacent to the gate electrode of PMOS transistor 904.

Device 1000 includes first memory access lines, e.g., bit line BL, and a second memory access lines, e.g., word lines WL1, WL2. Bit line BL is between the first and second transistors Q1, Q2 and the first and second capacitors C1, C2. Similarly, word lines WL1, WL2 are between the first and second transistors Q1, Q2 and the first and second capacitors C1, C2. Word lines WL1 and WL2 may extend in a direction orthogonal to bit line BL. In addition, first and second plate lines PL1, PL2 are between the front side (first surface 302) and the array of memory cells, e.g., plate lines PL1 and PL2 are over the first and second memory cells.

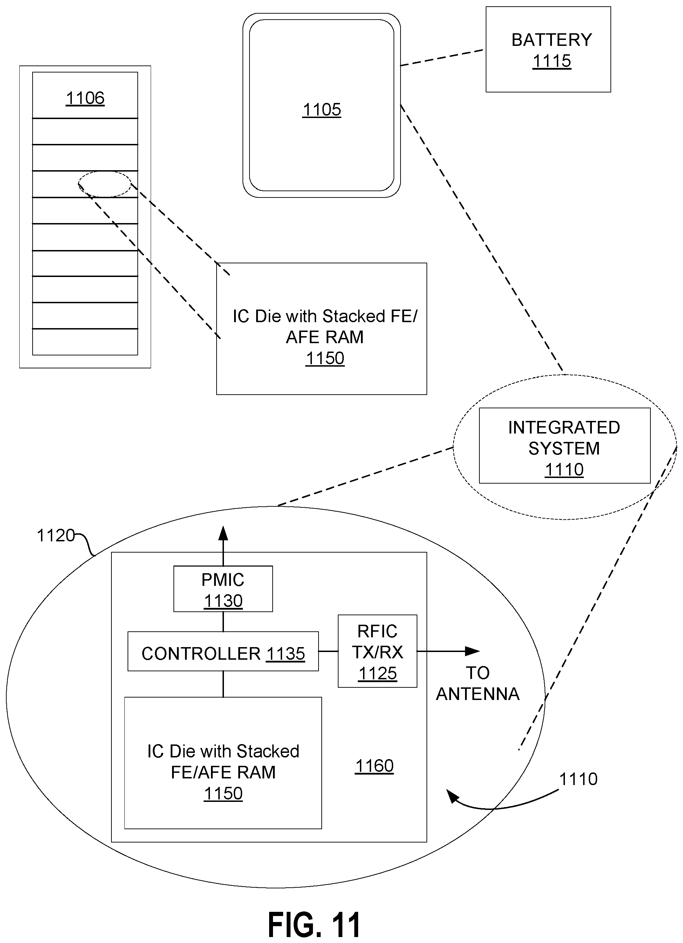

**FIG. 11** illustrates a mobile computing platform and a data server machine employing one or more apparatus comprising an IC package comprising an IC die comprising an array of memory cells comprising stacked NV Ferroelectric RAM, for example as described elsewhere herein. For example, mobile computing platform 1105 or server machine 1106 may include an IC package comprising IC die with an array of memory cells comprising stacked NV Ferroelectric RAM, as described elsewhere herein. Server machine 1106 may be any commercial server, for example including any number of high-performance computing platforms disposed within a rack and networked together for electronic data processing. The mobile platform 1105 may be any portable device configured for each of electronic data display, electronic data processing, wireless electronic data transmission, or the like. For example, the mobile computing platform 1105 may be any of a tablet, a smart phone, laptop computer, etc., and may include a display screen (e.g., a capacitive, inductive, resistive, or optical touchscreen), a chip-level or package-level integrated system 1110, and a battery 1115.

Whether disposed within the integrated system 1110 illustrated in the expanded view 1120, or as a stand-alone package within the server machine 1106, the IC die 1150 with an array of memory cells comprising stacked NV Ferroelectric RAM, as described elsewhere herein. IC die 1150 may be further coupled to a host substrate 1160, along with, one or more of a power management integrated circuit (PMIC) 1130, RF (wireless) integrated circuit (RFIC) 1125 including a wideband RF (wireless) transmitter and/or receiver (TX/RX) (e.g., including a digital baseband and an analog front-end module further comprises a power amplifier on a transmit path and a low noise amplifier on a receive path), and a controller 1135. PMIC 1130 may perform battery power regulation, DC-to-DC conversion, etc., and so has an input coupled to battery 1115 and with an output providing a current supply to other functional modules. As further illustrated, in the exemplary embodiment, RFIC 1125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 4G, and beyond.

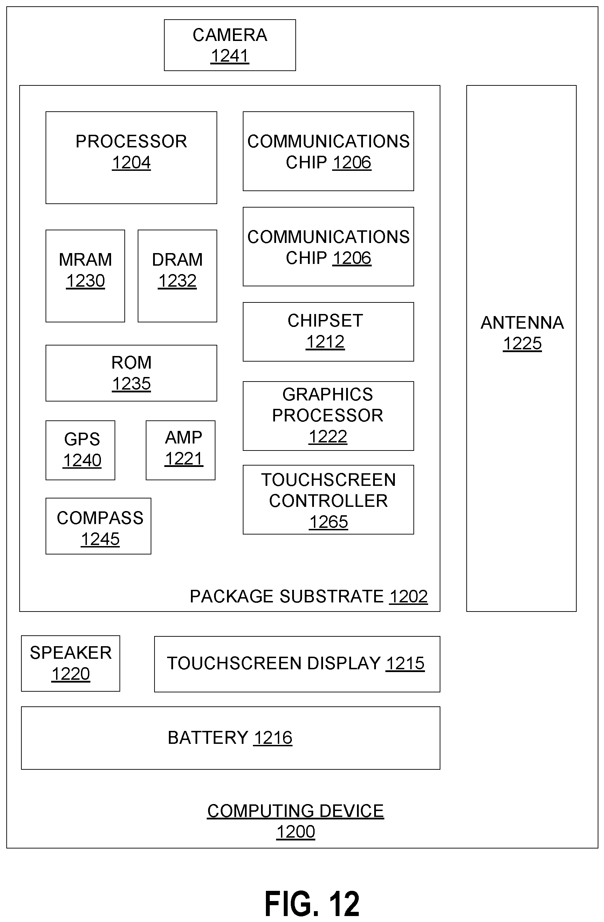

FIG. 12 is a functional block diagram of an electronic computing device 1200, in accordance with an embodiment of the present invention. The computing device may be found inside mobile computing platform 1105 or server machine 1106, as described elsewhere herein. Device 1200 further includes a package substrate 1202 hosting a number of components, such as, but not limited to, a processor 1204 (e.g., an applications processor). Processor 1204 may be physically and/or coupled to package substrate 1202. In general, the term "processor" or "microprocessor" may refer to any device or portion of a device that processes electronic data from registers and/or memory to transform that electronic data into other electronic data that may be further stored in registers and/or memory. In some examples, one or more of the components of computing device 1200 includes an IC die 1150 an array of memory cells comprising stacked NV Ferroelectric RAM, as described elsewhere herein.

In various examples, one or more communication chips 1206 may also be physically and/or coupled to the package substrate 1202. In further implementations, communication chips 1206 may be part of processor 1204. Depending on its applications, computing device 1200 may include other components that may or may not be physically and coupled to package substrate 1202. These other components include, but are not limited to, volatile memory (e.g., DRAM 1232), non-volatile memory (e.g., ROM 1235), flash memory (e.g., NAND or NOR), magnetic memory (MRAM 1230), a graphics processor 1222, a digital signal processor, a crypto processor, a chipset 1212, an antenna 1225, touchscreen display 1215, touchscreen controller 1265, battery 1216, audio codec, video codec, power amplifier 1221, global positioning system (GPS) device 1240, compass 1245, accelerometer, gyroscope, speaker 1220, camera 1241, and mass storage device (such as hard disk drive, solid-state drive (SSD), compact disk (CD), digital versatile disk (DVD), and so forth), or the like..

Communication chips 1206 may enable wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 1206 may implement any of a number of wireless standards or protocols. As discussed, computing device 1200 may include a plurality of communication chips 1206. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

Example 1: An integrated circuit (IC) die, comprising: an array of memory cells between a first surface and a second surface opposite the first surface, the array of memory cells comprising: a first memory cell proximate the first surface comprising a first capacitor over a first transistor, the first capacitor comprising first and second terminals, the first transistor comprising a first gate electrode and a first source electrode coupled with the first terminal; and a second memory cell under the first memory cell, the second memory cell comprising a second capacitor under a second transistor, the second capacitor comprising third and fourth terminals, the second transistor comprising a second gate electrode and a second source electrode coupled with the third terminal, wherein the first and second gate electrodes are adjacent and coupled; first and second plate lines between the first surface and the array of memory cells, the first plate line coupled with the second terminal; and a via electrically coupling the fourth terminal with the second plate line.

Example 2: The IC die of example 1, wherein the first and second capacitors comprise a ferroelectric or an antiferroelectric material.

Example 3: The IC die of example 1 or example 2, further comprising a first memory access line between the first transistor and the first capacitor, wherein: the first transistor further comprises a first drain electrode, and the second transistor further comprises a second drain electrode; and the first memory access line is coupled with the first and second drain electrodes.

Example 4: The IC die of any of examples 1 through 3, further comprising a second memory access line between the first transistor and the first capacitor, wherein the first gate electrode is coupled with the second memory access line.

Example 5: The IC die of any of examples 1 through 4, wherein the via is a first via and the array of memory cells further comprises: a third memory cell proximate the first surface and laterally adjacent to the first memory cell, the third memory cell comprising a third capacitor over a third transistor, the third capacitor comprising fifth and sixth terminals, the third transistor comprising a third gate electrode and a third source electrode coupled with the fifth terminal; and a fourth memory cell under the third memory cell, the fourth memory cell comprising a fourth capacitor under a fourth transistor, the fourth capacitor comprising seventh and eighth terminals, the fourth transistor comprising a fourth gate electrode and a fourth source electrode coupled with the seventh terminal, wherein the third and fourth gate electrodes are adjacent and coupled; third and fourth plate lines between the first surface and the array of memory cells, the third plate line coupled with the sixth terminal; and a second via electrically coupling the eighth terminal with the fourth plate line.

Example 6: The IC die of any of examples 1 through 5, wherein: the third transistor further comprises a third drain electrode, and the fourth transistor further comprises a fourth drain electrode; and the first memory access line is coupled with the third and fourth drain electrodes.

Example 7: The IC die of any of examples 1 through 6, further comprising a sidewall orthogonal to the first surface, first and second regions between the first and second surfaces, and peripheral circuitry, wherein the second region is between the first region and the sidewall, the array of memory cells are in the first region, and the peripheral circuitry is in the second region.

Example 8: The IC die of example 7, wherein the peripheral circuitry is coupled with the first and second plate lines and comprises capacitor biasing circuitry, the capacitor biasing circuitry comprising CMOS transistors.

Example 9: An integrated circuit (IC) die, comprising: a first surface and a second surface opposite the first surface; a first memory cell proximate the first surface comprising a first capacitor over a first transistor, the first capacitor comprising an insulating material between first and second terminals, the first transistor comprising a first source electrode coupled with the first terminal, and a first drain electrode, wherein the insulating material is a ferroelectric or an antiferroelectric material; a second memory cell under the first memory cell, the second memory cell comprising a second capacitor under a second transistor, the second capacitor comprising the insulating material between third and fourth terminals, the second transistor comprising a second source electrode coupled with the third terminal, and a second drain electrode; and a bit line between the first transistor and the first capacitor, wherein the bit line is coupled with the first drain electrode and the second drain electrode.

Example 10: The IC die of example 9 or example 10, further comprising: a first plate line between the first surface and the first memory cell, wherein the first plate line is coupled with the second terminal and capacitor bias circuitry; and a second plate line between the second surface and the second memory cell, wherein the second plate line is coupled with the third terminal and the capacitor bias circuitry.

Example 11: The IC die of example 9, further comprising a word line between the first transistor and the first capacitor, wherein the word line is coupled with a first gate electrode of the first transistor and a second gate electrode of the second transistor.

Example 12: The IC die of any of examples 9 through 11, further comprising: a third memory cell proximate the first surface and laterally adjacent to the first memory cell, the third memory cell comprising a third capacitor over a third transistor, the third capacitor comprising the insulating material between fifth and sixth terminals, the third transistor comprising a third source electrode coupled with the fifth terminal; and a fourth memory cell under the third memory cell, the fourth memory cell comprising a fourth capacitor under a fourth transistor, the fourth capacitor comprising the insulating material between seventh and eighth terminals, the fourth transistor comprising a fourth source electrode coupled with the seventh terminal; a third plate line between the first surface and the third memory cell, wherein the third plate line is coupled with the sixth terminal; and a fourth plate line between the second surface and the fourth memory cell, wherein the fourth plate line is coupled with the eighth terminal.

Example 13: The IC die of any of examples 9 through 12, further comprising a sidewall orthogonal to the first surface, first and second regions between the first and second surfaces, and peripheral circuitry, wherein the second region is between the first region and the sidewall, the first and second memory cells are in the first region, and the peripheral circuitry is in the second region.

Example 14: The IC die of example 13, wherein the peripheral circuitry comprises capacitor biasing circuitry comprising CMOS transistors.

Example 15: The IC die of example 13 or example 14, wherein the second plate line is in a back side power delivery layer may comprising a plurality of power interconnects.

Example 16: A system, comprising: an integrated circuit (IC) die comprising: a memory array comprising: first and second capacitors proximate a first surface, each capacitor comprising a ferroelectric or an antiferroelectric material between first and second terminals; a first access transistor under the first capacitor comprising a first electrode and a second electrode coupled with the first terminal of the first capacitor; a second access transistor under the second capacitor comprising a third electrode and a fourth electrode coupled with the first terminal of the second capacitor; first memory access lines over the first and second capacitors, each first memory access line coupled with one of the second terminals; and circuitry comprising a first transistor and a laterally adjacent second transistor, wherein the first access transistor is over and proximate the first transistor and the second access transistor is over and proximate and the second transistor, and the circuitry is between the memory array and a second surface opposite the first surface.

Example 17: The system of example 16, wherein the first transistor is a PMOS transistor and the second transistor is an NMOS transistor.

Example 18: The system of example 16 or example 17, wherein the circuitry is peripheral memory circuitry comprising capacitor biasing circuitry.

Example 19: The system of any of examples 16 through 18, wherein the memory array further comprises a second memory access line between the first transistor and the first capacitor, and the second memory access line is coupled with the first and third electrodes.

Example 20: The system of any of examples 16 through 19, further comprising a power supply coupled with the IC die to power the memory array.

## Claims

1. An integrated circuit (IC) die, comprising:
an array of memory cells between a first surface and a second surface opposite the first surface, the array of memory cells comprising:
a first memory cell proximate the first surface comprising a first capacitor over a first access transistor, the first capacitor comprising a ferroelectric or an antiferroelectric material between first and second terminals, the first access transistor comprising a first source electrode coupled with the first terminal, and a first gate electrode; and
a first plate line between the first surface and the array of memory cells, the first plate line coupled with the second terminal.

2. The IC die of claim 1, wherein the array of memory cells further comprises:
a second memory cell under the first memory cell, the second memory cell comprising a second capacitor under a second access transistor, the second capacitor comprising a ferroelectric or an antiferroelectric material between third and fourth terminals, the second access transistor comprising a second source electrode coupled with the third terminal, and a second gate electrode, wherein the first and second gate electrodes are adjacent and coupled;
a second plate line between the first surface and the array of memory cells; and
a via electrically coupling the fourth terminal with the second plate line.

3. The IC die of claim 1, wherein the array of memory cells further comprises:
a second memory cell under the first memory cell, the second memory cell comprising a second capacitor under a second access transistor, the second capacitor comprising a ferroelectric or an antiferroelectric material between third and fourth terminals, the second access transistor comprising a second source electrode coupled with the third terminal, and a second gate electrode, wherein the first and second gate electrodes are adjacent and coupled; and
a second plate line between the second surface and the second memory cell, wherein the second plate line is coupled with the fourth terminal.

4. The IC die of claim 3, wherein the second plate line is in a back side power delivery layer comprising a plurality of power interconnects.

5. The IC die of any of claims 2 to 4, further comprising a first memory access line between the first access transistor and the first capacitor, wherein:
the first access transistor further comprises a first drain electrode, and the second access transistor further comprises a second drain electrode; and
the first memory access line is coupled with the first and second drain electrodes.

6. The IC die of any of claims 1 to 5, further comprising a second memory access line between the first access transistor and the first capacitor, wherein the first gate electrode is coupled with the second memory access line.

7. The IC die of any of claims 2 to 5, wherein the array of memory cells further comprises:
a third memory cell proximate the first surface and laterally adjacent to the first memory cell, the third memory cell comprising a third capacitor over a third access transistor, the third capacitor comprising a ferroelectric or an antiferroelectric material between fifth and sixth terminals, the third access transistor comprising a third source electrode coupled with the fifth terminal, and a third gate electrode; and
a fourth memory cell under the third memory cell, the fourth memory cell comprising a fourth capacitor under a fourth access transistor, the fourth capacitor comprising a ferroelectric or an antiferroelectric material between seventh and eighth terminals, the fourth access transistor comprising a fourth source electrode coupled with the seventh terminal, and a fourth gate electrode, wherein the third and fourth gate electrodes are adjacent and coupled.

8. The IC die of any of claims 1 to 7, further comprising a sidewall orthogonal to the first surface, first and second regions between the first and second surfaces, and peripheral circuitry, wherein the second region is between the first region and the sidewall, the array of memory cells are in the first region, and the peripheral circuitry is in the second region.

9. The IC die of claim 8, wherein the peripheral circuitry is coupled with the array of memory cells and comprises capacitor biasing circuitry, the capacitor biasing circuitry comprising CMOS transistors.

10. The IC die of claim 1, wherein the array of memory cells further comprises:
a second memory cell proximate the first surface and laterally adjacent to the first memory cell, the second memory cell comprising a second capacitor over a second access transistor, the second capacitor comprising a ferroelectric or an antiferroelectric material between third and fourth terminals, the second access transistor comprising a second source electrode coupled with the third terminal, and a second gate electrode; and
a second plate line between the first surface and the array of memory cells, the second plate line coupled with the fourth terminal; and
circuitry comprising a first transistor and a second transistor laterally adjacent to the first transistor, wherein the first access transistor is over the first transistor and the second access transistor is over the second transistor, and the circuitry is between the array of memory cells and the second surface.

11. The IC die of claim 10, further comprising a first memory access line between the first access transistor and the first capacitor, wherein:
the first access transistor further comprises a first drain electrode, and the second access transistor further comprises a second drain electrode; and
the first memory access line is coupled with the first and second drain electrodes.

12. The IC die of claim 11, further comprising:
a second memory access line between the first access transistor and the first capacitor, wherein the second memory access line is orthogonal to the first memory access line and coupled with the first gate electrode; and
a third memory access line between the second access transistor and the second capacitor, wherein the third memory access line is orthogonal to the first memory access line and coupled with the second gate electrode.

13. The IC die of any of claims 10 to 12, wherein the first transistor is a PMOS transistor and the second transistor is an NMOS transistor.

14. The IC die of any of claims 10 to 13, wherein the circuitry is peripheral memory circuitry comprising capacitor biasing circuitry.

15. The IC die of any of claims 1 to 14, further comprising a power supply coupled with the IC die to power the array of memory cells.
